# EUROPÄISCHE PATENTANMELDUNG

(11) **EP 4 443 183 A1**
(43) Veröffentlichungstag der Anmeldung: **09.10.2024**
(21) Anmeldenummer: 24164926.8
(22) Anmeldetag: 20.03.2024
(51) Int. Cl.: G01R 33/02, B01F 33/452

(54) **RÜHRVORRICHTUNG FÜR EINEN MAGNETRÜHRER**

(30) Priorität: 23.03.2023 DE 102023202613
(71) Anmelder: 2mag AG, 80992 München (DE)
(72) Erfinder: KRESS, Kai, 80639 München (DE); FISCHER, Michael, 81545 München (DE); KAUFMANN, Klaus, 81827 München (DE)
(74) Vertreter: Mathys & Squire

(57) **Zusammenfassung**

Die Erfindung betrifft eine Rührvorrichtung (10) für einen Magnetrührer (200), aufweisend wenigstens zwei Magnetspulen (20) mit jeweils wenigstens einem Polschuh (22) für die Erzeugung eines rotierenden Antriebs-Magnetfeldes (AM), weiter aufweisend eine Sensorvorrichtung (30) mit wenigstens einem Magnetfeldsensor (32) mit einer Erkennungsrichtung (ER) für eine Erkennung von Magnetfeldlinien (M) eines Magnetfeldes entlang der Erkennungsrichtung (ER) und mit einer von der Erkennungsrichtung (ER) unterschiedlichen Blindrichtung (BR), in welcher der Magnetfeldsensor (30) blind für die Erkennung von Magnetfeldlinien (M) ausgebildet ist, wobei weiter die Blindrichtung (BR) des wenigstens einen Magnetfeldsensors (32) entlang der Magnetfeldlinien (M) des Antriebs-Magnetfeldes (AM) ausgerichtet ist.

## Beschreibung

Die vorliegende Erfindung betrifft eine Rührvorrichtung für einen Magnetrührer sowie ein Rührsystem mit zumindest zwei solcher Rührvorrichtungen.

Es ist bekannt, dass Rührvorrichtungen eingesetzt werden, um einen Magnetrührer in Rotation zu versetzen. Beispielsweise werden bei biologischen, biotechnologischen oder pharmazeutischen Anwendungen häufig Situationen vorgefunden, bei welchen flüssige Medien verrührt werden müssen. Dieses Rühren muss häufig über einen längeren Zeitraum stattfinden, zum Beispiel um bei einer Überwachung von Zellkulturen diese gut durchmischt zu halten. Bekannte Lösungen weisen hierfür Magnetrührer auf, welche als Rührstäbe in entsprechende Glasbehälter eingesetzt werden. Unterhalb dieser Glasbehälter ist eine Aufnahmefläche für den Glasbehälter vorgesehen, unter welcher wiederum einzelne Magnetspulen ein rotierendes Magnetfeld erzeugen. Dieses rotierende Magnetfeld nimmt den Magnetrührer bzw. den Rührstab mit und erzeugt damit die gewünschte Rotation des Rührstabes sowie der entsprechenden Flüssigkeit in dem Glasbehälter.

Nachteilhaft bei den bekannten Lösungen ist es, dass durch äußere Einwirkungen, aber auch durch Fehlbedienung sowie nicht vorhersehbare Einflüsse der Magnetrührer bzw. der Rührstab aus dieser Mitnahmesituation herausbewegt werden kann. Dies kann zum Beispiel dadurch geschehen, dass eine Blockade im Inneren des Behälters vorliegt, sodass der Rührstab nicht mehr von dem rotierenden Magnetfeld mitgenommen und in Rotation versetzt werden kann. Da solche Vorrichtungen häufig über sehr lange Zeiträume von mehreren Stunden oder sogar Tagen betrieben werden sollen, ist jedoch für den Erfolg des darin befindlichen Versuchs entscheidend, ob und in welcher Weise die Rührfunktion tatsächlich über die gesamte Zeitdauer gewährleistet worden ist. Bekannte Vorrichtungen verwenden dabei üblicherweise optische Überwachungen, welche in der Lage sind, mit Kamerasystemen die Rührfunktion zumindest qualitativ zu überwachen. Dies bedeutet einen sehr hohen Aufwand, da zusätzlich zur Rührvorrichtung und den Behältern selbst auch die entsprechende Kammervorrichtung nicht nur angeordnet, sondern auch justiert und eingerichtet werden muss.

Es ist Aufgabe der vorliegenden Erfindung, die voranstehend beschriebenen Nachteile zumindest teilweise zu beheben. Insbesondere ist es Aufgabe der vorliegenden Erfindung, in kostengünstiger und einfacher Weise einen Magnetrührer in Form eines Rührstabes zu überwachen.

Die voranstehende Aufgabe wird gelöst durch eine Rührvorrichtung mit den Merkmalen des Anspruchs 1 sowie ein Rührsystem mit den Merkmalen des Anspruchs 12. Weitere Merkmale und Details der Erfindung ergeben sich aus den Unteransprüchen, der Beschreibung und den Zeichnungen. Dabei gelten Merkmale und Details, die im Zusammenhang mit der erfindungsgemäßen Rührvorrichtung beschrieben sind, selbstverständlich auch im Zusammenhang mit dem erfindungsgemäßen Rührsystem und jeweils umgekehrt, sodass bezüglich der Offenbarung zu den einzelnen Erfindungsaspekten stets wechselseitig Bezug genommen wird bzw. werden kann.

Erfindungsgemäß ist eine Rührvorrichtung für einen Magnetrührer vorgesehen und weist wenigstens zwei Magnetspulen mit jeweils wenigstens einem Polschuh für die Erzeugung eines rotierenden Antriebs-Magnetfeldes auf. Weiter ist die Rührvorrichtung mit einer Sensorvorrichtung mit wenigstens einem Magnetfeldsensor mit einer Erkennungsrichtung für eine Erkennung von Magnetfeldlinien eines Magnetfeldes entlang der Erkennungsrichtung ausgestattet. Dieser wenigstens eine Magnetfeldsensor weist darüber hinaus eine von der Erkennungsrichtung unterschiedliche Blindrichtung auf, in welcher dieser Magnetfeldsensor blind für die Erkennung von Magnetfeldlinien ausgebildet ist. Weiter ist die Blindrichtung des wenigstens einen Magnetfeldsensors entlang der Magnetfeldlinien des Antriebs-Magnetfeldes ausgerichtet.

Unter einer Erkennung von Magnetfeldlinien ist im Sinne der vorliegenden Erfindung die grundsätzliche Erkennung eines Magnetfeldes in der Erkennungsrichtung zu verstehen. In Blindrichtung kann damit kein Magnetfeld erkannt werden. Eine Erkennung von Magnetfeldlinien im Sinne der vorliegenden Erfindung ist also insbesondere bereits durch die grundsätzliche Erkennung eines Magnetfeldes gegeben.

Erfindungsgemäß basiert also eine Rührvorrichtung auf den bekannten Lösungen, indem sie wenigstens zwei Magnetspulen mit jeweils wenigstens einem Polschuh zur Verfügung stellen. In bekannter Weise können die Magnetspulen und die Polschuhe verwendet werden, um ein rotierendes Antriebs-Magnetfeld zu erzeugen. Dieses Antriebs-Magnetfeld ist also in der bekannten Weise in der Lage, einen darauf angeordneten Magnetrührer einzufangen und ebenfalls durch Mitnahme mit dem Antriebs-Magnetfeld in eigene Rotation zu versetzen.

Erfindungsgemäß ist die Rührvorrichtung jedoch zusätzlich mit einer Sensorvorrichtung ergänzt. Diese Sensorvorrichtung ist in der Lage, Magnetfeldlinien zu erkennen. In einfachster Weise handelt es sich dabei um eine rein qualitative Erkennung, sodass der Magnetfeldsensor das Vorhandensein der Magnetfeldlinien von einem Fehlen von Magnetfeldlinien unterscheiden kann. Selbstverständlich sind jedoch auch quantitative Magnetfeldsensoren im Sinne der vorliegenden Erfindung für die Sensorvorrichtung einsetzbar, um auch die Stärke und/oder die Richtung der jeweiligen Magnetfeldlinien bestimmen zu können.

Die erfindungsgemäße Sensorvorrichtung ist dabei zumindest hinsichtlich der Erkennungsrichtung und der Blindrichtung mit einer Besonderheit ausgestattet. So sind für die Sensorvorrichtung zwei Richtungen zu unterscheiden, in welchen unterschiedliche Erkennungsfunktionen gegeben sind. In der Erkennungsrichtung, also entlang dieser Erkennungsrichtung, können Magnetfeldlinien entweder qualitativ und/oder quantitativ erkannt werden. In einer von dieser Erkennungsrichtung unterschiedlichen Blindrichtung kann eine solche Erkennung nicht stattfinden, da in dieser Blindrichtung der Magnetfeldsensor blind für die Erkennung von Magnetfeldlinien entlang dieser Blindrichtung ist. Das bedeutet also, dass Magnetfeldlinien eines Magnetfeldes, welche entlang der Blindrichtung verlaufen, vom Magnetfeldsensor nicht erkannt werden können. Ein entsprechender Signalausgang der Sensorvorrichtung bzw. des Magnetfeldsensors wird also bei einem fehlenden Magnetfeld wie auch bei einem Magnetfeld mit Magnetfeldlinien ausschließlich entlang der Blindrichtung die gleiche Ausgabe senden, nämlich ein Fehlen eines Magnetfeldes.

Sobald jedoch Magnetfeldlinien außerhalb der Blindrichtung zumindest teilweise entlang der Erkennungsrichtung ausgerichtet sind, kann ein solcher Magnetfeldsensor diese Magnetfeldlinien nun wahrnehmen, erkennen und ein entsprechendes Ausgabesignal generieren.

Die erfindungsgemäße Unterscheidung zwischen der Erkennungsrichtung und der Blindrichtung führt dazu, dass die Sensorvorrichtung bzw. der Magnetfeldsensor nun entlang des Antriebs-Magnetfeldes angeordnet werden kann. Dies erfolgt derart, dass die Blindrichtung des wenigstens einen Magnetfeldsensors entlang der Magnetfeldlinien des Antriebs-Magnetfeldes ausgerichtet ist. Dies führt zu der nachfolgend beschriebenen möglichen Sensorfunktionalität.

Sobald die Magnetspulen der Rührvorrichtung ein Antriebs-Magnetfeld erzeugen, stellen sich entsprechend des Antriebs-Magnetfeldes Magnetfeldlinien ein. Diese Magnetfeldlinien sind üblicherweise entlang einer entsprechenden Ebene ausgerichtet, welche das Antriebs-Magnetfeld aufspannt. Erfindungsgemäß ist nun die Blindrichtung des wenigstens einen Magnetfeldsensors in dieser Ebene bzw. parallel zu dieser Ebene ausgerichtet, sodass die Magnetfeldlinien des Antriebs-Magnetfeldes nicht oder nur in sehr geringem Maße wahrgenommen werden und erkannt werden können. Der Ausgabewert der Sensorvorrichtung beim angelegten Antriebs-Magnetfeld unterscheidet sich also nicht oder nur zu einem sehr geringen Teil von der Situation mit ausgeschalteten Magnetspulen, also ohne einem Antriebs-Magnetfeld.

Wird nun auf das rotierende Antriebs-Magnetfeld der Magnetrührer in Form des Rührstabes aufgesetzt, so entsteht ein Kombinations-Magnetfeld. Dies beruht darauf, dass der Magnetrührer bzw. der Rührstab ein eigenes Magnetfeld zur Verfügung stellt. Dieses eigene Magnetfeld beruht auf der Tatsache, dass der Magnetrührer bzw. der Rührstab eine eigene Magnetisierung, insbesondere in Form eines Permanentmagneten aufweist. Somit beeinflussen sich nun das Magnetfeld des Magnetrührers und das Antriebs-Magnetfeld gegenseitig, sodass ein kombiniertes Kombinations-Magnetfeld entsteht. Dadurch, dass sich nun die Magnetfeldlinien des Magnetfelds des Magnetrührers und die Magnetfeldlinien des Antriebs-Magnetfeldes gegenseitig beeinflussen, wird im Kombinations-Magnetfeld eine andere Ausrichtung der Magnetfeldlinien, insbesondere eine gebeugte Form des Antriebs-Magnetfeldes sich als Kombinations-Magnetfeld ausbilden. Mit Bezug auf die Sensorvorrichtung und insbesondere den Magnetfeldsensor führt dies dazu, dass nun auch die Magnetfeldlinien nicht mehr ausschließlich entlang der Blindrichtung ausgerichtet sind, sondern durch den Einfluss des Magnetrührers in gebeugter Weise zumindest teilweise sich auch entlang der Erkennungsrichtung erstrecken. Dies führt nun wiederum dazu, dass in der Erkennungsrichtung diese gebeugten Magnetfeldlinien erkennbar sind und ein entsprechendes Sensorsignal von der Sensorvorrichtung bzw. den Magnetfeldsensor abgebbar ist.

Ausgehend von der voranstehend erläuterten Funktionsweise wird es nun also möglich, ein bestehendes Antriebs-Magnetfeld ohne Magnetrührer von einem bestehenden Antriebs-Magnetfeld mit aufgesetztem Magnetrührer zu unterscheiden. Diese Unterscheidung ist exakt die Überwachungsfunktion, die erfindungsgemäß zur Verfügung gestellt sein soll. Im Allgemeinen reicht dabei grundsätzlich eine rein qualitative Auswertung aus. So ist es grundsätzlich in einem ersten Schritt schon vorteilhaft, wenn die Anwesenheit des Magnetrührers im Bereich des Antriebs-Magnetfeldes durch die Sensorvorrichtung und den Magnetfeldsensor wahrgenommen werden kann. Durch feinere Auflösung und insbesondere durch eine quantitative Auswertung der Sensordaten des Magnetfeldsensors können über die reine Anwesenheit des Magnetrührers auch die Mitrotation bzw. weitere Daten wie der Schleppwinkel bzw. der Schlupf des Magnetrührers über den Magnetfeldsensor ausgelesen werden. Diese Auslesemöglichkeit basiert auf dem Kerngedanken der vorliegenden Erfindung, nämlich der Ausgestaltung von Blindrichtung und Erkennungsrichtung am wenigstens einen Magnetfeldsensor und der entsprechenden Ausrichtungskorrelation der Blindrichtung mit den Magnetfeldlinien des Antriebs-Magnetfeldes.

Dabei ist es erfindungsgemäß unerheblich, ob es sich bei dem Magnetfeldsensor um einen aktiven oder einen passiven Magnetfeldsensor handelt. Auch ist es in einem ersten Schritt unerheblich, ob hier eine rein qualitative Auswertung oder bereits eine quantitative Auswertung erfolgt. Nicht zuletzt kann sowohl zeitlich zu definierten oder sogar nur zu einem einzigen Zeitpunkt gemessen werden, während selbstverständlich eine kontinuierliche, regelmäßige oder semikontinuierliche Überwachung des Antriebs-Magnetfeldes bzw. des Magnetrührers durch den wenigstens einen Magnetfeldsensor entsprechende Vorteile mit sich bringt.

Es ist vorteilhaft, wenn bei einer erfindungsgemäßen Rührvorrichtung die Sensorvorrichtung wenigstens zwei Magnetfeldsensoren an unterschiedlichen Positionen mit gleicher oder im Wesentlichen gleicher Ausrichtung aufweist, wobei die wenigstens zwei Magnetfeldsensoren insbesondere identisch oder im Wesentlichen identisch ausgebildet sind. Dies erlaubt zum einen eine redundante Überwachung der Magnetrührer. So kann selbst beim Ausfall eines Magnetfeldsensors der andere Magnetfeldsensor die Überwachungsfunktion weiter gewährleisten. Jedoch wird insbesondere bei qualitativer, aber bevorzugt bei quantitativer Auswertung der Magnetfeldsensoren hier ein weiterer Vorteil erzielbar. So kann auf diese Weise zum Beispiel der Schleppwinkel und/oder der Schlupf des Magnetrührers relativ zum erzeugten Antriebs-Magnetfeld erkannt werden. Insbesondere kann zum Beispiel die Frequenz des umlaufenden Kombinations-Magnetfeldes mit der Frequenz des Antriebs-Magnetfeldes verglichen werden. Eine quantitative Analyse lässt sich auf diese Weise also weiter verbessern.

Weitere Vorteile sind erzielbar, wenn bei einer erfindungsgemäßen Rührvorrichtung die Sensorvorrichtung einen Montagekörper aufweist mit einem Befestigungsabschnitt zur Befestigung in der definierten Ausrichtung, insbesondere zur Befestigung an wenigstens einem Polschuh. Ein solcher Montagekörper kann zum Beispiel aus Kunststoff ausgebildet sein oder ein Kunststoffmaterial aufweisen. Er erlaubt es, die Ausrichtung der Sensorvorrichtung in der erfindungsgemäß definierten Weise durch den Montagekörper zur Verfügung zu stellen. In einfachster Weise ist dabei der Befestigungsabschnitt als formschlüssiger Befestigungsabschnitt ausgestaltet, und kann zum Beispiel durch Aufsetzen, Einrasten, aber auch durch ein formschlüssiges Fertigen, zum Beispiel durch ein Umgießen, in der gewünschten Befestigungsposition angeordnet werden. Dies erlaubt es, mit hoher Sicherheit die Sensorvorrichtung in der gewünschten definierten Ausrichtung der Blindrichtung des Magnetfeldsensors tatsächlich innerhalb der Rührvorrichtung zu positionieren.

Bei einer Ausführungsform gemäß dem voranstehenden Absatz ist es von Vorteil, wenn bei der Rührvorrichtung der Montagekörper über den Befestigungsabschnitt an allen Polschuhen befestigt ist. Da über die Polschuhe die Ausrichtung des Magnetfelds definiert wird, kann durch die Anbindung in befestigender Weise an allen Polschuhen auch die entsprechende erfindungsgemäße Ausrichtung der Blindrichtung weiter verbessert werden. Insbesondere werden die einzelnen Polschuhe über den Befestigungsabschnitt in Relation zu der Sensorvorrichtung bzw. dem wenigstens einen Magnetfeldsensor zueinander ausgerichtet und hinsichtlich ihrer Relativposition definiert. Mit anderen Worten kann auf diese Weise durch den Befestigungsabschnitt und den Montagekörper sowie über die Polschuhe und damit auch über den Magnetfeldsensor eine definierte Antriebsebene zur Verfügung gestellt werden, welche der Ebene des Antriebs-Magnetfeldes entspricht oder im Wesentlichen entspricht.

Vorteile bringt es weiter mit sich, wenn bei einer erfindungsgemäßen Rührvorrichtung der wenigstens eine Magnetfeldsensor zwischen zwei benachbarten Polschuhen, insbesondere mittig zwischen zwei benachbarten Polschuhen angeordnet ist. Eine Anordnung mittig zwischen den Polschuhen ist insbesondere auch als symmetrische Anordnung zwischen den beiden benachbarten Polschuhen zu verstehen. In diesem Bereich ist am meisten Platz für die Anordnung des wenigstens einen Magnetfeldsensors, sodass eine kompakte Anordnung innerhalb der Rührvorrichtung möglich wird. Auch kann insbesondere durch eine Symmetrie zum entsprechenden Antriebs-Magnetfeld auch eine vereinfachte Auswertung der Messsignale erfolgen. Dabei wird die tatsächliche Position, insbesondere die Winkelposition des wenigstens einen Magnetfeldsensors, bei der Auswertung, insbesondere in quantitativer Weise berücksichtigt.

Ebenfalls vorteilhaft ist es, wenn bei einer erfindungsgemäßen Rührvorrichtung gemäß dem voranstehenden Absatz der wenigstens eine Magnetfeldsensor in einem Spalt zwischen zwei benachbarten Polschuhen angeordnet ist. Dabei wird der wenigstens eine Magnetfeldsensor also in das Antriebs-Magnetfeld zwischen zwei benachbarte Polschuhe integriert. Die Kompaktheit der Bauweise der gesamten Rührvorrichtung wird auf diese Weise deutlich verbessert. Es können besonders kleine Magnetfeldsensoren verwendet werden, da sie durch die Integration in das Antriebs-Magnetfeld in diesen Spalt zwischen den Polschuhen den maximalen Messbezug zu dem Antriebs-Magnetfeld zur Verfügung stellen.

Weitere Vorteile sind erzielbar, wenn bei einer erfindungsgemäßen Rührvorrichtung der wenigstens eine Magnetfeldsensor bündig oder im Wesentlichen bündig mit einer Antriebsebene des Antriebs-Magnetfeldes angeordnet ist. Mit anderen Worten kann die Antriebsebene auch als die Rührebene bzw. die Rühroberfläche verstanden werden, auf welcher der Glasbehälter mit dem Magnetrührer aufgesetzt wird. Die entsprechende Höhe der Polschuhe definiert dabei vorzugsweise die Antriebsebene des Antriebs-Magnetfeldes, sodass dementsprechend der Magnetfeldsensor mit seiner Messebene bündig und insbesondere direkt auf Höhe der entsprechenden Antriebsebene, also zum Beispiel auf Höhe der Polschuhe angeordnet ist. Die Ausrichtung und Einbindung der erfindungsgemäßen Blindrichtung des wenigstens einen Magnetfeldsensors kann auf diese Weise weiter verbessert werden.

Ein weiterer Vorteil ist erzielbar, wenn bei einer erfindungsgemäßen Rührvorrichtung die Blindrichtung des wenigstens einen Magnetfeldsensors senkrecht oder im Wesentlichen senkrecht zu Erkennungsrichtung ausgebildet ist. Diese Ausrichtung erlaubt eine maximale Unterscheidbarkeit zwischen Blindrichtung und Erkennungsrichtung, sodass eine Umsetzung des Sensors bzw. die Auswertung der Sensordaten noch einfacher möglich wird. Die Genauigkeit in der Bestimmung wird auf diese Weise sowohl in qualitativer als auch in quantitativer Hinsicht deutlich gesteigert. Selbstverständlich können jedoch auch unterschiedliche Korrelationen zwischen Blindrichtung und Magnetfeldsensor zur Verfügung gestellt sein. Mit anderen Worten kann auch die Blindrichtung, die senkrecht auf einer Blindebene steht, und die Erkennungsrichtung, die senkrecht auf einer Erkennungsebene steht, so ausgerichtet sein, dass die Blindebene und die Erkennungsebene zueinander senkrecht ausgebildet sind.

Ebenfalls von Vorteil ist es, wenn bei einer erfindungsgemäßen Rührvorrichtung der wenigstens eine Magnetfeldsensor eine radiale Position aufweist, welche der radialen Erstreckung des Antriebs-Magnetfeldes entspricht oder im Wesentlichen entspricht. Darunter ist zu verstehen, dass vom Mittelpunkt zwischen allen Magnetspulen ausgehend eine radiale Position des Magnetfeldsensors definierbar ist. Damit kann eine Korrelation mit der radialen Erstreckung des Antriebs-Magnetfeldes zur Verfügung gestellt werden, sodass sich der Magnetfeldsensor möglichst innerhalb, insbesondere vollständig innerhalb des Antriebs-Magnetfeldes befindet. Da üblicherweise die Länge des Magnetrührers bzw. des Rührstabes mit der radialen Erstreckung des Antriebs-Magnetfeldes korreliert, befindet sich der Magnetfeldsensor damit radial automatisch auch in der entsprechenden Position im Bereich des Rührstabes.

Ebenfalls vorteilhaft ist es, wenn bei einer erfindungsgemäßen Rührvorrichtung der wenigstens eine Magnetfeldsensor als aktiver Magnetfeldsensor ausgebildet ist. Darunter ist insbesondere ein analoger Magnetfeldsensor zu verstehen. Neben den Sensorleitungen sind also Versorgungsleitungen für eine elektrische Energieversorgung für den Magnetfeldsensor einer solchen Ausbildung vorgesehen.

Ebenfalls von Vorteil ist es, wenn bei einer erfindungsgemäßen Rührvorrichtung der wenigstens eine Magnetfeldsensor radial außerhalb der Polschuhe angeordnet ist. Dies erlaubt eine besonders einfache Anordnung, welche auch ein nachträgliches Anordnen an einer Rührvorrichtung erlaubt. Auch können auf diese Weise größere Magnetfeldsensoren eingesetzt werden, welche entweder hinsichtlich der Erkennungsgenauigkeit oder aber hinsichtlich einer Kostenreduktion Vorteile mit sich bringen. Auch der Montageaufwand und der Eingriff in bestehende Konstruktionsweisen der Rührvorrichtung wird auf diese Weise verbessert.

Ebenfalls Gegenstand der vorliegenden Erfindung ist ein Rührsystem mit wenigstens zwei Rührvorrichtungen gemäß der vorliegenden Erfindung für ein Erzeugen von wenigstens zwei drehenden Antriebs-Magnetfeldern. Damit bringt ein erfindungsgemäßes Rührsystem die gleichen Vorteile mit sich, wie sie ausführlich mit Bezug auf die erfindungsgemäße Rührvorrichtung erläutert worden sind.

Vorteilhaft ist es, wenn bei einem erfindungsgemäßen Rührsystem die Magnetfeldsensoren der Rührvorrichtungen über eine Multiplexereinheit kontrolliert werden. Die Multiplexereinheit kann also die Kontrolle, insbesondere die Steuerung und/oder die Regelung der Magnetfeldsensoren übernehmen. Auch ist es grundsätzlich denkbar, dass in der Multiplexereinheit entsprechende Auswertschritte oder sogar die komplette Auswertung der Daten der Magnetfeldsensoren zur Verfügung gestellt werden. Über die Multiplexereinheit ist es möglich, die Magnetfeldsensoren der Rührvorrichtungen gleichzeitig oder nacheinander zeitlich nachgeschaltet zu überwachen. So wird es auch möglich, Rührsysteme mit einer Vielzahl von einzelnen Rührvorrichtungen einfach, kostengünstig und vor allem über die Multiplexereinheit zentral kontrolliert zu überwachen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen schematisch:
- Figur 1: eine Ausführungsform einer erfindungsgemäßen Rührvorrichtung,
- Figur 2: die Ausführungsform der Figur 1 mit einem zusätzlichen Montagekörper,
- Figur 3: eine Darstellung eines Antriebs-Magnetfeldes,
- Figur 4: eine Darstellung eines Kombinations-Magnetfeldes,
- Figur 5: eine weitere Ausführungsform einer Rührvorrichtung,
- Figur 6: eine weitere Ausführung einer Rührvorrichtung in seitlicher Darstellung und
- Figur 7: eine Ausführungsform eines erfindungsgemäßen Rührsystems.

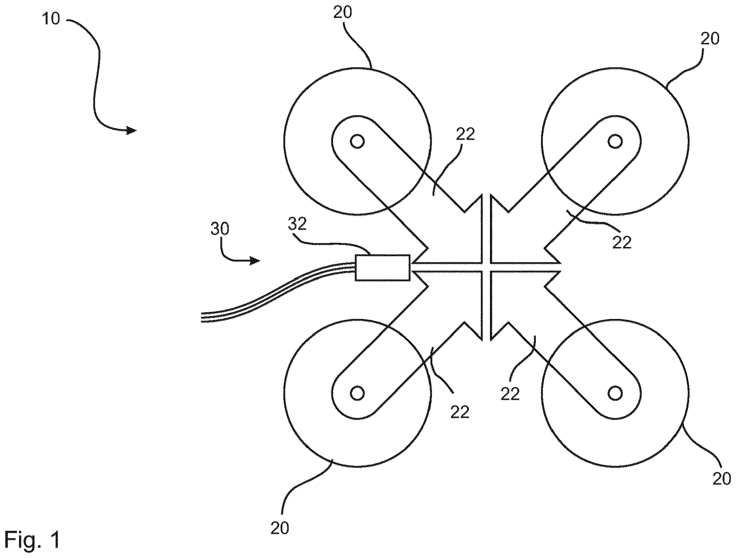

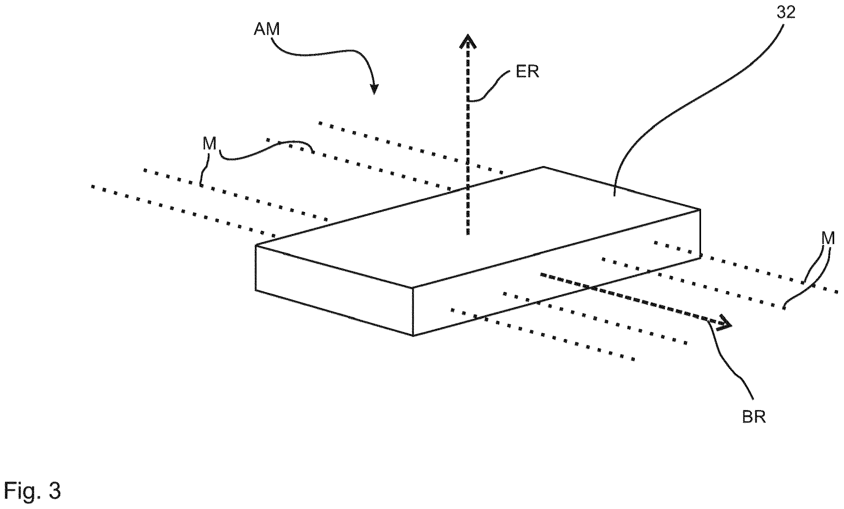

In Figur 1 ist eine einfachste Ausführungsform einer erfindungsgemäßen Rührvorrichtung 10 dargestellt. Diese ist mit vier Magnetspulen 20 mit jeweils einem Polschuh 22 ausgebildet. Über die Bestromung der vier Magnetspulen 20 und die entsprechende Weiterleitung der entstehenden Magnetfelder über die Polschuhe 22 lässt sich ein rotierendes Antriebs-Magnetfeld AM erzeugen, wie es insbesondere in der Figur 3 dargestellt ist. Zusätzlich ist gemäß der Figur 1 in der Rührvorrichtung 10 eine Sensorvorrichtung 30 seitlich angeordnet, welche mit einem Magnetfeldsensor 32 ausgestattet ist. Dieser Magnetfeldsensor 32 befindet sich dabei zwischen den beiden linken benachbarten Polschuhen 22 und ist dort in der Lage, Magnetfeldlinien M wahrzunehmen.

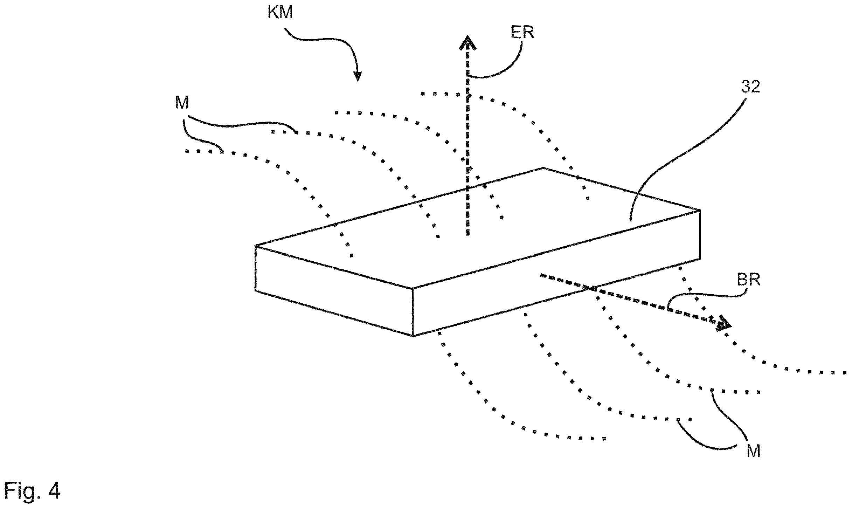

Die Funktionsweise wird dabei insbesondere mit Bezug auf die Figuren 3 und 4 näher erläutert. In der Figur 3 ist schematisch als Block der Magnetfeldsensor 32 dargestellt. Er weist im Wesentlichen zwei unterschiedliche Richtungen auf, welche sich hinsichtlich ihrer Funktionalität voneinander unterscheiden. Senkrecht nach oben in Figur 3 ist die Erkennungsrichtung ER ausgerichtet, entlang welcher Magnetfeldlinien M, welche durch den Magnetfeldsensor 32 zumindest teilweise entlang der Erkennungsrichtung ER verlaufen, qualitativ und/oder quantitativ erkannt werden können. Von der Erkennungsrichtung ER unterschiedlich, hier senkrecht nach rechts ausgerichtet dazu, erstreckt sich die Blindrichtung BR des Magnetfeldsensors 32. Magnetfeldlinien M, welche entlang der Blindrichtung BR ausgerichtet sind, können nicht oder im Wesentlichen nicht von dem Magnetfeldsensor 32 erkannt werden. Somit unterscheidet sich das Sensorsignal bei Magnetfeldlinien M entlang der Blindrichtung BR nicht oder nur unwesentlich von einer Situation ohne ein entsprechendes Magnetfeld.

In Figur 3 ist nun die Situation dargestellt, wenn bei einer Ausführungsform einer Rührvorrichtung 10, zum Beispiel gemäß Figur 1, ein Antriebs-Magnetfeld AM durch die Magnetspulen 20 erzeugt wird. Entsprechende Magnetfeldlinien M bilden sich aus und sind durch die erfindungsgemäße Ausrichtung des Magnetfeldsensors 32 entlang dessen Blindrichtung BR ausgerichtet. Der Magnetfeldsensor 32 ist also nicht oder im Wesentlichen nicht in der Lage, entlang dieser Blindrichtung die Magnetfeldlinien M des Antriebs-Magnetfelds AM zu erkennen. Wird nun für die Durchführung einer Rühraufgabe ein Magnetrührer 200, zum Beispiel in Form eines Rührstabes, in das Antriebs-Magnetfeld AM eingebracht, so erzeugen die Magnetfeldlinien des Antriebs-Magnetfeldes AM und die Magnetfeldlinien M des Magnetrührers 200 eine Kombination von Magnetfeldlinien M, also ein gebeugtes Antriebs-Magnetfeld AM, welches im Sinne der vorliegenden Erfindung als Kombinations-Magnetfeld KM bezeichnet werden kann, und zum Beispiel in Figur 4 (Rührstab aus Gründen der Übersichtlichkeit nicht dargestellt) dargestellt ist. Die entsprechend gebeugten Magnetfeldlinien M erstrecken sich nun teilweise auch entlang der Erkennungsrichtung ER und können nunmehr vom Magnetfeldsensor 32 wahrgenommen werden. Dabei zeigt die Figur 4 ein statisches Bild. Durch die Rotation des Magnetrührers 200 wird auch eine Rotation des gebeugten Kombinations-Magnetfelds KM erfolgen, sodass nicht nur qualitativ das gebeugte Kombinations-Magnetfeld KM, sondern insbesondere auch quantitativ die Bewegung des gebeugten Kombinations-Magnetfeldes KM durch den Magnetfeldsensor 32 möglich wird.

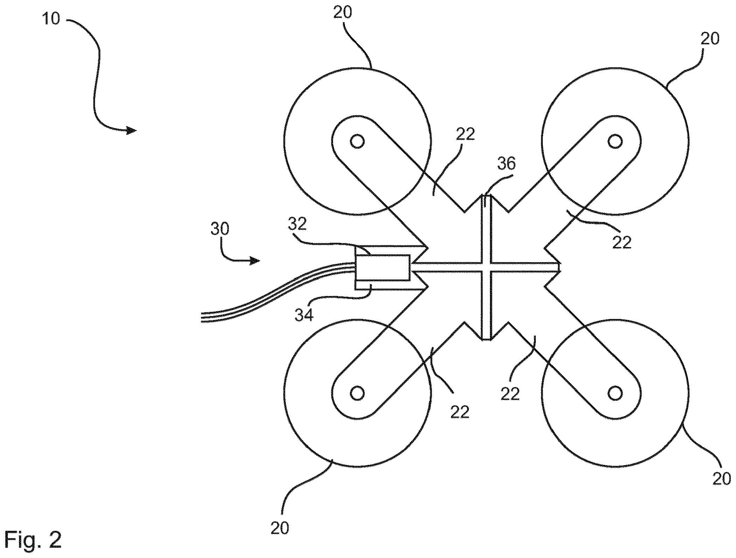

Die Rührvorrichtung 10 der Figur 2 ist eine Ausbildungsform der Figur 1, jedoch weitergebildet um eine erleichterte Montageform. So ist hier ein Montagekörper 34 vorgesehen, welcher mit einem Befestigungsabschnitt 36 ausgestattet ist. Der Befestigungsabschnitt 36 dient der Befestigung an allen vier Polschuhen 22. Gleichzeitig ist am Montagekörper 34 auch der Magnetfeldsensor 32 befestigt. Somit wird die Ausrichtung des Magnetfeldsensors 32 zu den Polschuhen 22 und damit zum Antriebs-Magnetfeld AM eindeutig definiert eingestellt und insbesondere in leichter und sicherer Weise montierbar.

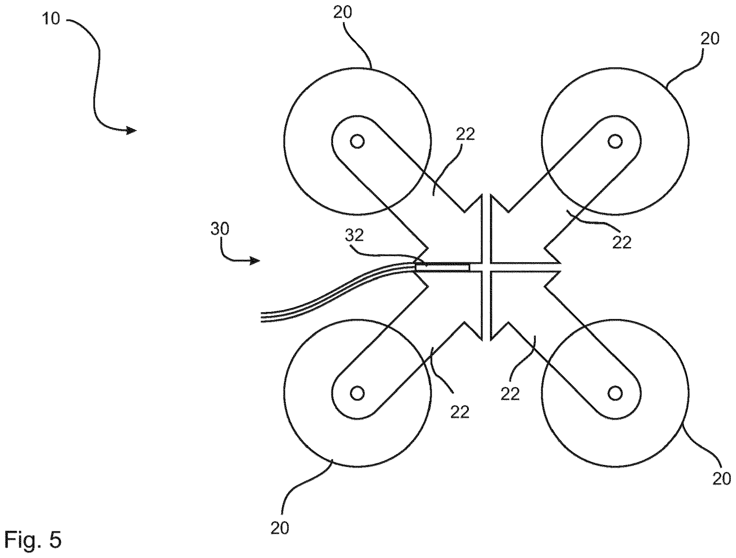

Bei der Figur 5 ist eine Rührvorrichtung 10 dargestellt, bei welcher der Magnetfeldsensor 32 in einen Spalt zwischen den Polschuhen 22 integriert ist. Bei dieser Variante ist eine besonders gute Integration in das Antriebs-Magnetfeld AM gegeben, sodass die qualitative und/oder quantitative Bestimmung der Magnetfeldlinien hier deutlich erleichtert und verbessert ist. Auch konnte ein kleinerer und kompakterer Magnetfeldsensor 32 verwendet werden, sodass eine kompakte Bauweise der gesamten Rührvorrichtungen 10 möglich wird.

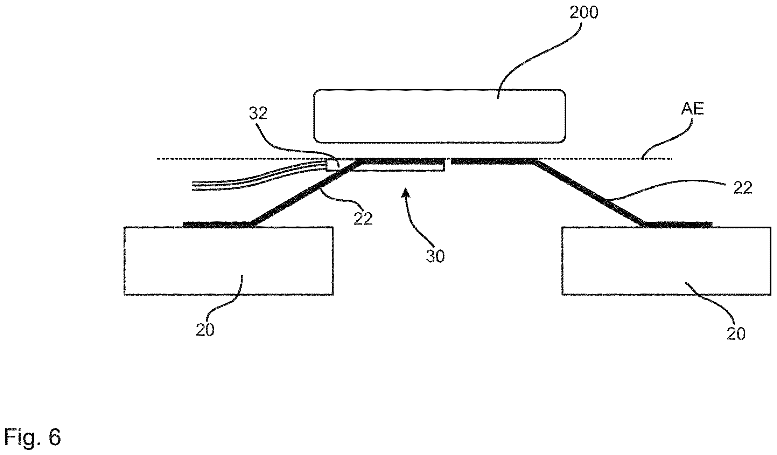

Figur 6 zeigt schematisch in einer Seitendarstellung die Ausführungsformen der Figuren 1, 2 und zum Beispiel der Figur 5. Hier ist gut zu erkennen, welche Höhenanordnung der Magnetfeldsensor 32 in Korrelation zu den Polschuhen 22 aufweisen kann. So ist hier die Sensorvorrichtung 30 mit einem Magnetfeldsensor 32 versehen, dessen Oberseite bzw. insbesondere dessen Erkennungsebene an oder in einer Antriebsebene AE ausgerichtet ist, welcher der Ebene des Antriebs-Magnetfeldes entspricht bzw. der Ebene des Aufsetzens des Magnetrührers 200. Alternativ zu der Darstellung der Figur 6 ist auch eine mittige oder im Wesentlichen mittige Anordnung bezogen auf die Polschuhe 22 und/oder bezogen auf die Rotationsachse des Rührstabes 200 möglich.

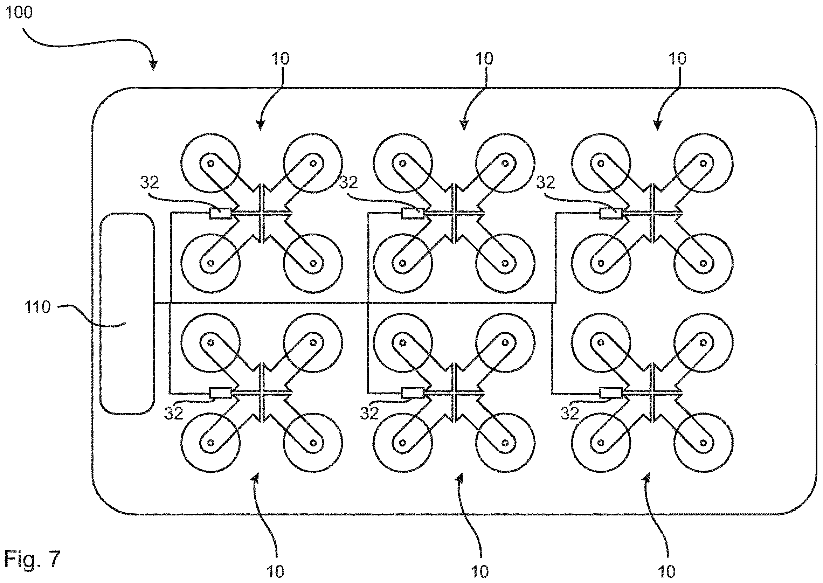

Figur 7 zeigt ein Rührsystem 100, welches hier mit sechs einzelnen Rührvorrichtungen 10 ausgestattet ist. Die einzelnen Rührvorrichtungen 10 sind jeweils mit einem Magnetfeldsensor 32 einer Sensorvorrichtung 30 zur Verfügung gestellt. Alle Magnetfeldsensoren 32 sind dabei sensorisch und kontrollierbar mit einer Multiplexereinheit 110 signaltechnisch verbunden. Somit kann über die Multiplexereinheit eine Kontrolle aller Magnetfeldsensoren 32 und damit aller Rührvorrichtungen 10 erfolgen. Dies kann sowohl hinsichtlich einer energetischen Versorgung, aber auch hinsichtlich einer Auswertung von Messsignalen gelten.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezuaszeichen

- 10: Rührvorrichtung
- 20: Magnetspule
- 22: Polschuh
- 30: Sensorvorrichtung
- 32: Magnetfeldsensor
- 34: Montagekörper
- 36: Befestigungsabschnitt

- 100: Rührsystem
- 110: Multiplexereinheit
- 200: Magnetrührer

- AE: Antriebsebene
- AM: Antriebs-Magnetfeld
- KM: Kombinations-Magnetfeld
- M: Magnetfeldlinie
- ER: Erkennungsrichtung
- BR: Blindrichtung

## Patentansprüche

1. Rührvorrichtung (10) für einen Magnetrührer (200), aufweisend wenigstens zwei Magnetspulen (20) mit jeweils wenigstens einem Polschuh (22) für die Erzeugung eines rotierenden Antriebs-Magnetfeldes (AM), weiter aufweisend eine Sensorvorrichtung (30) mit wenigstens einem Magnetfeldsensor (32) mit einer Erkennungsrichtung (ER) für eine Erkennung von Magnetfeldlinien (M) eines Magnetfeldes entlang der Erkennungsrichtung (ER) und mit einer von der Erkennungsrichtung (ER) unterschiedlichen Blindrichtung (BR), in welcher der Magnetfeldsensor (30) blind für die Erkennung von Magnetfeldlinien (M) ausgebildet ist, wobei weiter die Blindrichtung (BR) des wenigstens einen Magnetfeldsensors (32) entlang der Magnetfeldlinien (M) des Antriebs-Magnetfeldes (AM) ausgerichtet ist.

2. Rührvorrichtung (10) nach Anspruch 1, **dadurch gekennzeichnet, dass** die Sensorvorrichtung (30) wenigstens zwei Magnetfeldsensoren (32) an unterschiedlichen Positionen mit gleicher oder im Wesentlichen gleicher Ausrichtung aufweist, wobei die wenigstens zwei Magnetfeldsensoren (32) insbesondere identisch oder im Wesentlichen identisch ausgebildet sind.

3. Rührvorrichtung (10) nach einem der voranstehenden Ansprüche, **dadurch gekennzeichnet, dass** die Sensorvorrichtung (30) einen Montagekörper (34) aufweist mit einem Befestigungsabschnitt (36) zu Befestigung in der definierten Ausrichtung, insbesondere zur Befestigung an wenigstens einem Polschuh (22).

4. Rührvorrichtung (10) nach Anspruch 3, **dadurch gekennzeichnet, dass** der Montagekörper (34) über den Befestigungsabschnitt (36) an allen Polschuhen (22) befestigt ist.

5. Rührvorrichtung (10) nach einem der voranstehenden Ansprüche, **dadurch gekennzeichnet, dass** der wenigstens eine Magnetfeldsensor (32) zwischen zwei benachbarten Polschuhen (22), insbesondere mittig zwischen zwei benachbarten Polschuhen (22) angeordnet ist.

6. Rührvorrichtung (10) nach Anspruch 5, **dadurch gekennzeichnet, dass** der wenigstens eine Magnetfeldsensor (32) in einem Spalt zwischen zwei benachbarten Polschuhen (22) angeordnet ist.

7. Rührvorrichtung (10) nach einem der voranstehenden Ansprüche, **dadurch gekennzeichnet, dass** der wenigstens eine Magnetfeldsensor (32) bündig oder im Wesentlichen bündig mit einer Antriebsebene (AE) des Antriebs-Magnetfeldes (AM) angeordnet ist.

8. Rührvorrichtung (10) nach einem der voranstehenden Ansprüche, **dadurch gekennzeichnet, dass** die Blindrichtung (BR) des wenigstens einen Magnetfeldsensors (32) senkrecht oder im Wesentlichen senkrecht zur Erkennungsrichtung (ER) ausgebildet ist.

9. Rührvorrichtung (10) nach einem der voranstehenden Ansprüche, **dadurch gekennzeichnet, dass** der wenigstens eine Magnetfeldsensor (32) eine radiale Position aufweist, welche der radialen Erstreckung des Antriebs-Magnetfeldes (AM) entspricht oder im Wesentlichen entspricht.

10. Rührvorrichtung (10) nach einem der voranstehenden Ansprüche, **dadurch gekennzeichnet, dass** der wenigstens eine Magnetfeldsensor (32) als aktiver Magnetfeldsensor (32) ausgebildet ist.

11. Rührvorrichtung (10) nach einem der voranstehenden Ansprüche, **dadurch gekennzeichnet, dass** der wenigstens eine Magnetfeldsensor (32) radial außerhalb der Polschuhe (22) angeordnet ist.

12. Rührsystem (100) mit wenigstens zwei Rührvorrichtungen (10) mit den Merkmalen eines der Ansprüche 1 bis 11 für ein Erzeugen von wenigstens zwei drehenden Antriebs-Magnetfeldern (AM).

13. Rührsystem (100) nach Anspruch 12, **dadurch gekennzeichnet, dass** die Magnetfeldsensoren (32) der Rührvorrichtungen (10) über eine Multiplexereinheit (110) kontrolliert werden.
